**Europäisches Patentamt**

**European Patent Office**

**Office européen des brevets**

(19)

(11) Veröffentlichungsnummer: **0 170 061**
**B1**

(12)

# EUROPÄISCHE PATENTSCHRIFT

(45) Veröffentlichungstag der Patentschrift:
**07.01.88**

(21) Anmeldenummer: **85107985.5**

(22) Anmeldetag: **27.06.85**

(51) Int. Cl.⁴: **H 05 K 1/14,** H 05 K 3/36

(54) **Steck- und Ziehwerkzeug.**

(30) Priorität: **12.07.84 DE 8420924 U**

(43) Veröffentlichungstag der Anmeldung:
**05.02.86 Patentblatt 86/6**

(45) Bekanntmachung des Hinweises auf die Patenterteilung:
**07.01.88 Patentblatt 88/1**

(84) Benannte Vertragsstaaten:
**AT BE CH DE FR GB IT LI NL SE**

(56) Entgegenhaltungen:
**DE - A - 2 843 018**
**DE - A - 3 127 454**
**FR - A - 1 571 937**
**GB - A - 2 025 145**
**US - A - 4 427 316**

(73) Patentinhaber: **Siemens Aktiengesellschaft Berlin und München, Wittelsbacherplatz 2, D-8000 München 2 (DE)**

(72) Erfinder: **Voigt, Ulrich, Dipl.-Ing., Unertlstrasse 31, D-8000 München 40 (DE)**

## Beschreibung

Die Erfindung betrifft ein Steck- und Ziehwerkzeug zum Stecken oder Ziehen einer obersten Leiterplatte in einem Leiterplattenstapel, welches durch Aneinanderreihung von auf der Ober- und Unterseite mit je einer Hälfte zweiteiliger Steckverbinder versehener Leiterplatten gebildet ist, wobei jede Leiterplatte beiderseits der Steckverbinderhälften schlüssellochförmige Aussparungen enthält.

Aufgabe der vorliegenden Erfindung ist es, ein Steck- und Ziehwerkzeug zum Stecken einer obersten Leiterplatte eines von mit ober- und unterseitig mit zweiteiligen Steckverbindern versehenen Leiterplatten gebildeten Stapels zu schaffen.

Zur Lösung dieser Aufgabe wird gemäss der Erfindung das Steck- und Ziehwerkzeug durch ein hohlzylindrisches Aussenteil mit einer rundumlaufenden, einer Leiterplattendicke entsprechenden, in der Höhe kleiner eines Leiterplattenabstands angebrachten Nut eines Stössels gebildet, dessen Stösselstange im Inneren des hohlzylindrischen Aussenteils in Richtung der Längsachse beweglich geführt ist und dessen Stösselplatte in ihrem Durchmesser dem Aussendurchmesser des Aussenteils entspricht.

Durch diese Massnahmen erhält man ein einfach ausgebildetes Steck- und Ziehwerkzeug für oberste Leiterplatten eines Leiterplattenstapels.

Anhand der Ausführungsbeispiele nach den Figuren 1 bis 4 wird die Erfindung näher erläutert.

Es zeigen:

Fig. 1 einen Leiterplattenstapel in perspektivischer Darstellung,

Fig. 2 die Seitenansicht eines Leiterplattenstapels,

Fig. 3 das Zieh- und Steckwerkzeug im Betriebszustand,

Fig. 4 die auf den Leiterplatten befindlichen Durchgangsöffnungen.

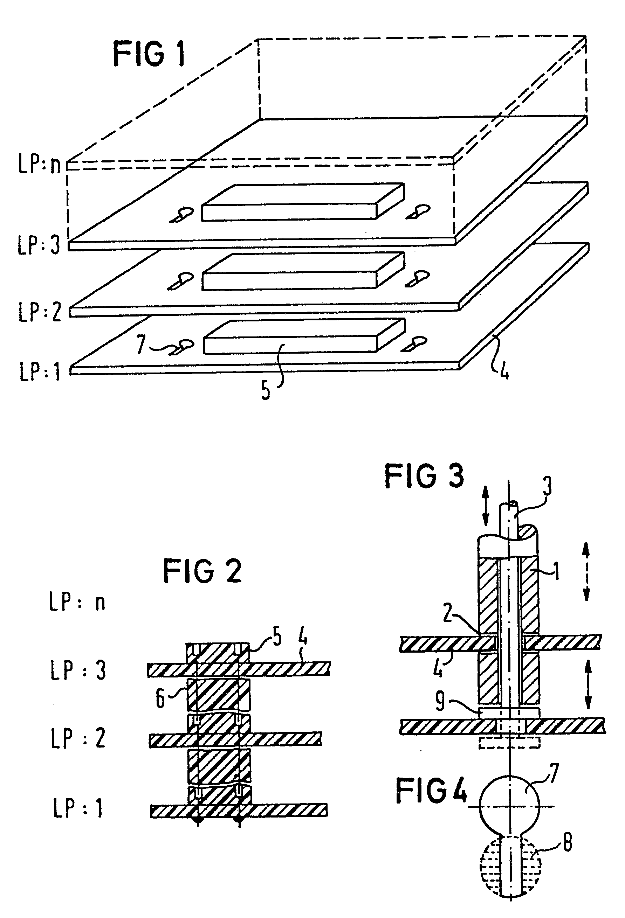

In Fig. 1 ist ein aus mehreren Leiterplatten 4 bestehender Stapel gezeigt, wobei die Leiterplatten über kombinierte Steckverbinder 5, 6 miteinander verbunden sind. Links und rechts neben den Steckverbinderteilen befindet sich je eine schlüssellochförmige Ausnehmung. Dieser Schnitt nach Fig. 2 lässt die beiden Teile 5 und 6 des zweiseitigen aber kombinierten Steckverbinders erkennen. Über diese Steckverbinder sind die einzelnen Leiterplatten miteinander verbunden.

Mit Hilfe eines Steck- und Ziehwerkzeuges, wie es in Fig. 3 im Einsatz gezeigt ist, wird jeweils die oberste Leiterplatte auf den Stapel aufgesetzt oder von diesem abgezogen. Das Steckwerkzeug besteht aus dem hohlzylindrischen Aussenteil 1, in dem ein Stössel, bestehend aus der Stösselstange 3 und der Stösselplatte 9 in axialer Richtung geführt ist. Die Stösselplatte 9 entspricht in ihrem Durchmesser dem Aussendurchmesser des hohlzylindrischen Aussenteils 1. Der Werkzeugbewegungsablauf ist dabei so, dass zunächst das zylindrische Aussenteil mitsamt der Stösselplatte 9 durch die kreisrunde Öffnung der schlüssellochförmigen Aussparung 7 so weit hindurchgesteckt wird, bis die an der Aussenseite des Aussenteils angebrachte Nut 2 in Höhe der Leiterplatte liegt. Dann wird das Werkzeug durch die Nut geführt und horizontal verschoben.

Anschliessend wird entweder gedrückt oder gezogen, je nachdem ob die Platte vom Stapel abgezogen oder auf den Stapel aufgepresst werden soll. Anschliessend wird das Werkzeug horizontal von dem schlitzförmigen Auslauf der schlüssellochförmigen Aussparung in die kreisrunde Öffnung zurückgeschoben und kann dann wieder aus der Leiterplatte herausgehoben werden.

Eine schlüssellochförmige Aussparung ist in Fig. 4 gezeigt. Sie besteht aus einer kreisrunden Öffnung 7, die mit einem schlitzartigen Fortsatz verbunden ist. In diesem schlitzartigen Fortsatz wird durch die Nut 2 (Fig. 3) das Aussenteil des Steck- und Ziehwerkzeuges geführt und gehalten.

## Patentanspruch

Steck- und Ziehwerkzeug zum Stecken und Ziehen einer obersten Leiterplatte in einem Leiterplattenstapel, welcher durch Aneinanderreihung von auf der Ober- und Unterseite mit je einer Hälfte zweiteiliger Steckverbinder versehener Leiterplatten gebildet ist, wobei jede Leiterplatte beiderseits der Steckverbinderhälften schlüssellochförmige Aussparungen enthält, gekennzeichnet durch ein hohlzylindrisches Aussenteil (1) mit einer rundumlaufenden, einer Leiterplattendicke entsprechenden in der Höhe kleiner eines Leiterplattenabstandes angebrachten Nut (2) und einem Stössel (3, 9) dessen Stösselstange (3) im Inneren des hohlzylindrischen Aussenteils (1) in Richtung der Längsachse beweglich geführt ist und dessen Stösselplatte (9) in ihrem Durchmesser dem Aussendurchmesser des Aussenteils (1) entspricht.

## Claim

Insertion and extraction tool for inserting or extracting an uppermost printed circuit board in a stack of printed circuit boards, which is formed by the series arrangement of printed circuit boards provided on each of their upper and lower sides with one half of a two-part plug connector, whereby each circuit board has, on both sides of the plug connector-halves, key-hole-shaped recesses, characterised by an outer component (1) in the form of a hollow cylinder with a circumferential groove (2) which corresponds to the thickness of one printed circuit board, and is arranged at a level which is less than the spacing between two circuit boards and with a plunger (3, 9), whose push rod (3) is in the interior of the hollow cylindrical outer part (1), being guided so as to be movable in the direction of the longitudinal axis and its head (9) corresponding in diameter to the external diameter of the outer part (1).

## Revendication

1. Outil d'insertion et d'extraction servant à réaliser l'insertion et l'extraction de la plaquette à circuits imprimés, qui est située dans la position la plus élevée, d'une pile de plaquettes à circuits imprimés, qui est formée par le rangement les unes contre les autres de plaquettes à circuits imprimés comportant, sur leur face supérieure et leur face inférieure, respectivement une moitié de connecteur formé de deux éléments, chaque plaquette à circuits imprimés comportant des évidements en forme de trous de serrure, sur les deux côtés des moitiés des connecteurs, caractérisé par une partie extérieure (1) en forme de cylindre creux comportant une gorge périphérique (2), dont la hauteur correspond à l'épaisseur des plaquettes à circuits imprimés et est inférieure à la distance entre lesdites plaquettes, et un poussoir (3, 9), dont la tige (3) est guidée à l'intérieur de la partie extérieure (1) en forme de cylindre creux de manière à être déplaçable en direction de l'axe longitudinal et dont le disque (9) possède un diamétre correspondant au diamètre extérieur de la partie extérieure (1).

# FIG 1

LP:n

LP:3

LP:2

LP:1

7

5

4

# FIG 2

LP : n

LP : 3

LP : 2

LP : 1

5  4

6

# FIG 3

3

1

2

4

9

# FIG 4

7

8